# EUROPEAN PATENT APPLICATION

(11) **EP 2 634 810 A2**
(43) Date of publication of application: **04.09.2013**
(21) Application number: 13156854.5
(22) Date of filing: 26.02.2013
(51) Int. Cl.: H01L 29/40, H01L 29/417, H01L 29/423, H01L 29/772, H01L 29/778

(54) **Field effect transistor**

(30) Priority: 01.03.2012 JP 2012045366
(71) Applicant: Kabushiki Kaisha Toshiba, Tokyo 105-8001 (JP)
(72) Inventor: Yamaura, Takuji, Minato-ku, Tokyo 105-8001 (JP)
(74) Representative: Granleese, Rhian Jane

(57) **Abstract**

A semiconductor device includes: a substrate; a gate electrode which is arranged on a first surface of the substrate and has a plurality of gate finger electrodes, a source electrode which is arranged on the first surface of the substrate and has a plurality of source finger electrodes, the source finger electrode is close to the gate finger electrode; a drain electrode which is arranged on the first surface of the substrate and has a plurality of drain finger electrodes, the drain finger electrode faces the source finger electrode via the gate finger electrode; and a shield plate electrode which is arranged on the drain finger electrode and the first surface of the substrate between the gate finger electrode and the drain finger electrode via an insulating layer, is short-circuited to the source finger electrode, and shields electrically the gate finger electrode and the drain finger electrode from each other.

## Description

### FIELD

Embodiments of a present invention relate to a semiconductor device.

### BACKGROUND

A source field plate is known as an electric field relaxation technique for a field effect transistor (FET). The source field plate arranged between a gate and a drain is capable of performing relaxation of electric field concentration near a gate electrode, and as a result, an FET improves a withstanding voltage thereof. In order to realize the relaxation of the electric field effectively, the source field plate is arranged near the gate electrode, or is arranged overlapping with the gate electrode.

As for an FET which operates at high frequency, such as a millimeter wave band, a high gain is expected when it operates at relatively low frequency, such as a microwave band etc. On the other hand, however, suppression of oscillation is difficult because amount of feedback becomes large.

The source field plate is effective in the suppression of oscillation. Since the source field plate short-circuited to the source is arranged near the gate, the source field plate, however, increases a capacitance Cgs between the gate and the source. As a result, gain of the FET is decreased.

### BRIEF DESCRIPTION OF THE DRAWINGS

Fig. 1 shows a schematic plane pattern structure of a semiconductor device concerning a first embodiment;
Fig. 2 shows a schematic plane pattern structure of a unit transistor portion in the semiconductor device concerning the first embodiment;
Fig. 3 shows a schematic cross section taken along a II-II line in Fig. 2;
Fig. 4 shows a schematic cross section taken along a I-I line in Fig. 1 in a constructional example 1 of an FET cell;
Fig. 5 shows a schematic cross section taken along a I-I line in Fig. 1 in a constructional example 2 of an FET cell;
Fig. 6 shows a schematic cross section taken along a I-I line in Fig. 1 in constructional example 3 of an FET cell;
Fig. 7 shows a schematic cross section taken along a I-I line in Fig. 1 in constructional example 4 of an FET cell;
Fig. 8 shows a schematic plane pattern structure of a high-frequency semiconductor device concerning a modification 1 of the first embodiment;
Fig. 9 shows a schematic plane pattern structure of a high-frequency semiconductor device concerning a modification 2 of the first embodiment;
Fig. 10 shows a schematic cross section taken along a III-III line in Fig. 9;
Fig. 11 shows another schematic cross section taken along a III-III line in Fig. 9;
Fig. 12 shows a schematic plane pattern structure of a unit transistor portion of a semiconductor device concerning a second embodiment;
Fig. 13 shows a schematic cross section taken along a IV-IV line in Fig. 12;
Fig. 14 shows a schematic plane pattern structure of a high-frequency semiconductor device concerning modification 1 of second embodiment;
Fig. 15 shows a schematic plane pattern structure of a high-frequency semiconductor device concerning modification 2 of second embodiment;
Fig. 16 shows a schematic cross section taken along a V-V line in Fig. 15; and
Fig. 17 shows another schematic cross section taken along a line in Fig. 15.

### DETAILED DESCRIPTION

According to an embodiment, a semiconductor device includes: a substrate; a gate electrode which is arranged on a first surface of the substrate and has a plurality of gate finger electrodes, a source electrode which is arranged on the first surface of the substrate and has a plurality of source finger electrodes, the source finger electrode is close to the gate finger electrode; a drain electrode which is arranged on the first surface of the substrate and has a plurality of drain finger electrodes, the drain finger electrode faces the source finger electrode via the gate finger electrode; an insulating layer which covers the gate finger electrode, the substrate between the gate finger electrode and the source finger electrode, the substrate between the gate finger electrode and the drain finger electrode, at least a part of the source finger electrode, and at least a part of the drain finger electrode; and a shield plate electrode which is arranged on the drain finger electrode and the first surface of the substrate between the gate finger electrode and the drain finger electrode via the insulating layer, is short-circuited to the source finger electrode, and shields electrically the gate finger electrode and the drain finger electrode from each other.

An embodiment provides a semiconductor device of high gain. By arranging the shield plate electrode short-circuited to the source finger electrode near the drain finger electrode, the gate and the drain are shielded from each other, a capacitance Cgd between the gate and the drain is reduced and an increase in a capacitance Cgs between the gate and the source is suppressed.

Next, embodiments are described with reference to the drawings. In below, an explanation is simplified by giving the same numerals to the same elements and avoiding overlapping explanation of the same element. The drawings are schematic and you should be care about that they differ from an actual thing. In addition, among the drawings, the portions from which the relation and ratio of a mutual size differ are contained.

The embodiments shown below illustrate devices and methods for materializing a technical idea, and the embodiments do not specify arrangement of each component part, etc. as the followings. In these embodiments, various modifications may be made within claim coverage.

### [First embodiment]

### (Semiconductor device)

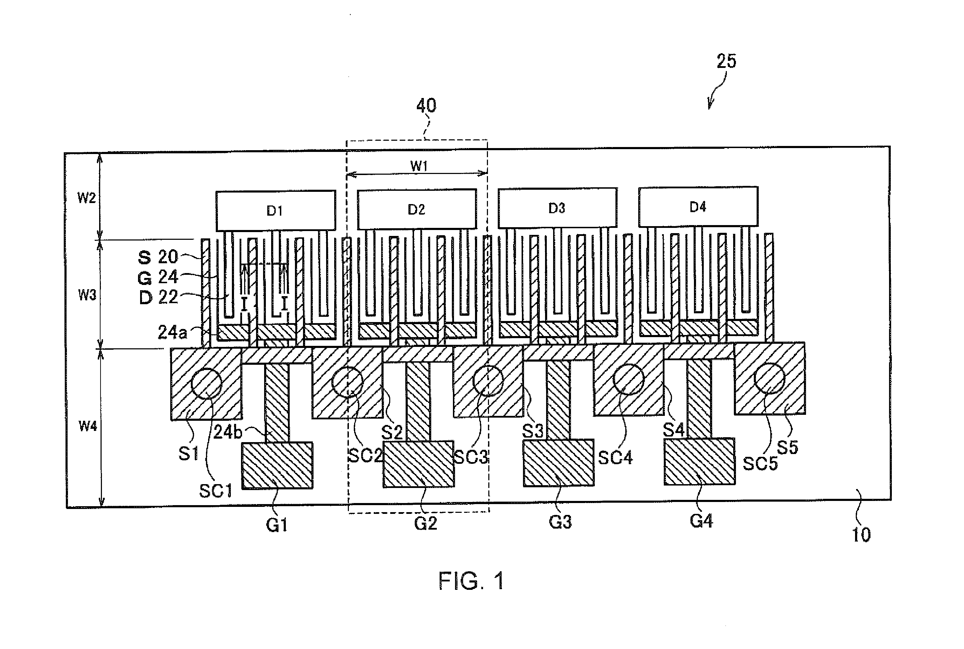

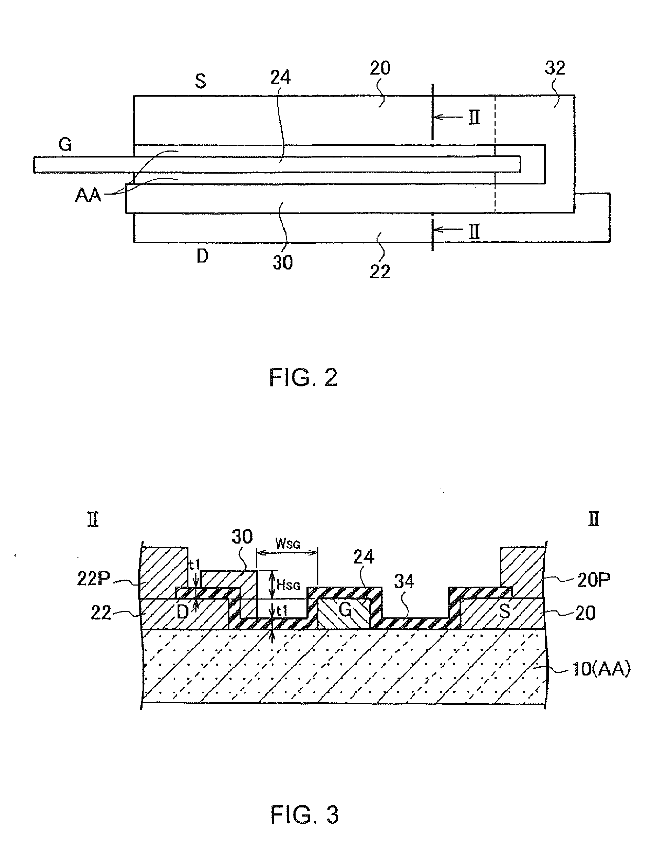

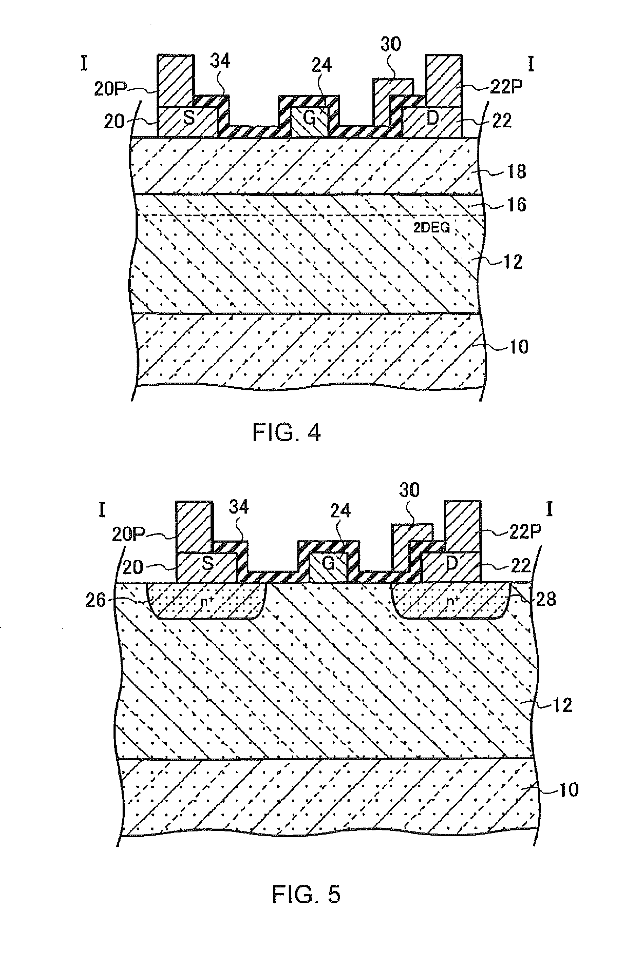

Fig. 1 shows a schematic plane pattern structure of a semiconductor device 25 concerning the first embodiment. Fig. 2 shows a schematic plane pattern structure of a unit transistor portion of the semiconductor device 25. Fig. 3 shows a schematic cross section taken along a II-II line in Fig. 2. In addition, in Fig. 1, although a shield plate electrode 30 and a shield plate short circuit line 32 as shown in Fig. 2 are arranged at each unit transistor portion like Fig. 2, in order to avoid complexity, illustration of the shield plate electrode 30 and the shield plate short circuit line 32 is omitted. Schematic cross sections taken along a I-I line in Fig. 1 are shown in Fig. 4 to Fig. 7.
In Fig. 4 to Fig. 7, the shield plate electrode 30 is shown in each drawing.

The semiconductor device 25 concerning the first embodiment is provided with a substrate 10, a gate electrode G, a source electrode S, a drain electrode D, an insulating layer 34, and the shield plate electrode 30 as shown in Fig. 1 to Fig. 3.

The gate electrode G is arranged on a first surface of the substrate 10, and has a plurality of gate finger electrodes 24. The source electrode S is arranged on the first surface of the substrate 10, and has a plurality of source finger electrodes 20. The source finger electrode 20 is arranged close to the gate finger electrode 24. The drain electrode D is arranged on the first surface of the substrate 10, and has a plurality of drain finger electrodes 22. The drain finger electrode 22 is arranged facing the source finger electrode 20 via the gate finger electrode 24. In a following explanation, the gate finger electrode 24 may be simply called a gate electrode 24, and the source finger electrode 20 may be simply called a source electrode 20, and the drain finger electrode 22 may be simply called a drain electrode 22.

As shown in Fig. 3, the insulating layer 34 is arranged so as to cover the gate electrode 24, the substrate 10 between the gate electrode 24 and the source electrode 20, the substrate 10 between the gate electrode 24 and the drain electrode 22, at least a part of the source electrode 20, and at least a part of the drain electrode 22.

As shown in Fig. 3, the shield plate electrode 30 is arranged via the insulating layer 34 on the first surface of the substrate 10 between the gate electrode 24 and the drain electrode 22, and on the drain electrode 22. The shield plate electrode 30 is short-circuited to the source electrode 20, and shields electrically the gate electrode 24 and the drain electrode 22 from each other.

The shield plate electrode 30 is separated from the gate electrode 24 by at least a distance WSG longer than a thickness t1 of the insulating layer 34, as shown in Fig. 3. By constituting thus, the effect of electric shield between the drain and the gate can be increased, and a capacitance Cgd between the gate and the drain can be reduced.
In addition, since the shield plate electrode 30 can be greatly separated from the gate electrode 24 as compared with a conventional source field plate, an increase in a capacitance Cgs between the gate and the source can be suppressed. Here, the shield plate electrode 30 should just be separated from the gate electrode 24 by at least the distance WSG longer than the thickness t1 of the insulating layer. Here, what is necessary is just WSG>0.

As shown in Fig. 2 and Fig. 3, the shield plate electrode 30 covers at least an upper part of the drain electrode 22 via the insulating layer 34.

As for an effect of the electric shield between the gate and the drain by the shield plate electrode 30, the thinner the thickness t1 of the insulating layer 34 is, the larger the effect to be expected is. In the case where the thickness t1 of the insulating layer 34 is relatively thick, the number of the lines of electric force which run the inside of the insulating layer 34 between the gate electrode 24 and the drain electrode 22 increases, and the effect of the electric shield between the gate electrode 24 and the drain electrode 22 is reduced. On the other hand, in the case where the thickness t1 of the insulating layer 34 is relatively thin, the number of the lines of electric force which run the inside of the insulating layer 34 between the gate electrode 24 and the drain electrode 22 decreases correspondingly to a thinned part of the insulating layer 34, and the effect of the electric shield between the gate electrode 24 and the drain electrode 22 is increased.

As shown in Fig. 3, a drain pad electrode 22P may be arranged on the drain electrode 22, and a source pad electrode 20P may be arranged on the source electrode 20. The drain pad electrode 22P and the source pad electrode 20P reduce resistance ingredient of the drain electrode D and the source electrode S which have finger structure, respectively.

In addition, the semiconductor device 25 concerning the first embodiment is provided with a shield plate short circuit line 32 of line structure which is arranged on the substrate 10 and which short-circuits the shield plate electrode 30 and the source electrode 20 as shown in Fig. 2.

In addition, as shown in Fig. 3, in the semiconductor device 25 concerning the first embodiment, an upper end of the shield plate electrode 30 measured from the first surface of the substrate 10 is higher than an upper end of the gate electrode 24 by only a height HSG. By constituting thus, the effect of the electric shield between the drain and the gate can be increased.

In the semiconductor device 25 concerning the first embodiment, by arranging the shield plate electrode 30 short-circuited to the source electrode 20 near the drain electrode 22, the drain and the gate are electrically shielded from each other and the capacitance Cgd between the gate and the drain is decreased, and furthermore the increase in the capacitance Cgs between the gate and the source can be suppressed. Accordingly, a concentration of the electric field between the gate and the drain can be relaxed without degrading a high-frequency characteristic.

In the semiconductor device 25 concerning the first embodiment, since the capacitance Cgd between the gate and the drain can be reduced, S parameter S12 can be reduced and the semiconductor device of high gain can be obtained.

The semiconductor device 25 concerning the first embodiment includes a plurality of FET cells 40, as shown in Fig. 1. The semiconductor device 25 includes: the semi-insulating substrate 10; the gate electrode G which is arranged on the first surface of the semi-insulating substrate 10 and has a plurality of the gate finger electrodes 24; the source electrode S which is arranged on the first surface of the semi-insulating substrate 10 and has a plurality of the source finger electrodes 20; the drain electrode D which is arranged on the first surface of the semi-insulating substrate 10 and has a plurality of the drain finger electrodes 22; gate terminal electrodes G1, G2 ..., G4 which are arranged on the first surface of the semi-insulating substrate 10, and are connected to a plurality of the gate finger electrodes 24; source terminal electrodes S1, S2, S3 ..., S5 which are arranged on the first surface of the semi-insulating substrate 10, and are connected to a plurality of the source finger electrodes 20; drain terminal electrode D1, D2 ..., D4 which are arranged on the first surface of the semi-insulating substrate 10 and which are connected to a plurality of the drain finger electrodes 22; VIA holes SC1, SC2, SC3 ... SC5 which are formed in the semi-insulating substrate 10 under the source terminal electrodes S1, S2, S3, ..., S5; and an ground electrode (not shown) which is arranged on a second surface opposite to the first surface of the semi-insulating substrate 10, and is connected to the source terminal electrodes S1, S2, S3 ..., S5 via the VIA holes SC1, SC2, SC3 ..., SC5.

In the FET cell 40, a plurality of the gate finger electrode 24 are connected to a gate bus line 24a, and the gate bus line 24a is connected to the gate terminal electrode G1 to G4 via a gate bus line 24b. Accordingly, the gate bus line 24a bundles a plurality of the gate finger electrode 24, and a plurality of the gate finger electrode 24 are connected to the gate terminal electrode G1 to G4. The source terminal electrode S1, S2, --, S5 bundle a plurality of the gate finger electrodes 24. The drain terminal electrode D1, D2, --, D4 bundle a plurality of the drain finger electrodes 22.

Input bonding wires are connected to the gate terminal electrode G1, G2, ..., G4, and output bonding wires are connected to the drain terminal electrode D1, D2, ..., D4.

Each of the VIA holes SC1, SC2, ..., SC5 includes a barrier metal layer (not shown) formed on an inner wall of a hole and a filling metal layer (not shown) formed on the barrier metal layer and with which the hole is filled up. The source terminal electrodes S1, S2, ..., S5 are connected to the ground electrode (not shown) via the barrier metal layers and the filling metal layers of the VIA holes SC1, SC2, ..., SC5.

The semi-insulating substrate 10 is any one of a GaAs substrate, an SiC substrate, a GaN substrate, a substrate in which a GaN epitaxial layer is formed on the SiC substrate, a substrate in which a hetero-junction epitaxial layer which consists of GaN/AlGaN is formed on the SiC substrate, a sapphire substrate, and a diamond substrate.

In addition, in the semiconductor device 25 concerning the first embodiment, the semiconductor device is provided with any one of a GaAs system HEMT, a GaAs MESFET and a GaN system HEMT. That is, in the semiconductor device 25 concerning the first embodiment, a semiconducting material suitable for high-frequency operations, such as GaN and GaAs, is used especially for the semiconductor device.

In an configuration example of Fig. 1, as for a size of each part, for example, a cell width W1 is about 120 micrometers, W2 is about 80 micrometers, a cell length W3 is about 100 micrometers, W4 is about 120 micrometers, and a gate width is about 2.40 mm (= 100 micrometers x 6 x 4 cell) as a whole.

On the other hand, there is also a structure where the VIA holes SC1 to SC5 are not arranged under the source terminal electrodes S1 to S5. In this case, a following configuration may be adopted. For example, in order to give a ground potential to the source terminal electrodes S1 to S5, a side electrode may be arranged on a side of the substrate 10, and the source terminal electrodes S1 to S5 and the the ground conductor arranged on the second surface of the substrate 10 may be connected via the side electrode. Or it is also possible to give the ground potential to the source terminal electrodes S1 to S5 by bonding wires. Or a VIA hole called a slot VIA may be formed to the source electrode 20 itself instead of providing the source terminal electrodes S1 to S5.

In the semiconductor device 25 concerning the first embodiment, as shown in Fig. 1, the gate bus lines 24a and 24b are arranged lower side of connection lines which connect the source electrodes 20 and the source terminal electrodes S1 to S5. However, on the contrary, the gate bus lines 24a and 24b may be arranged upper side of the connection lines which connect the source electrodes 20 and the source terminal electrodes S1 to S5.

In the semiconductor device 25 concerning the first embodiment, although the source terminal electrodes S1 to S5 are arranged near the gate terminal electrodes G1 to G4 as shown in Fig. 1, the source terminal electrodes S1 to S5 may be arranged near the drain terminal electrodes D1 to D4 on the contrary.

### (Structure of FET cell)

### (Constructional example 1)

Fig. 4 shows a constructional example 1 of an FET cell 40 by a schematic cross section taken along a I-I line in Fig. 1. The FET cell 40 includes: a substrate 10; an epitaxial layer 12 which is arranged on the substrate 10; an electron supplying layer 18 which is arranged on the epitaxial layer 12; a source electrode 20, a gate electrode 24, and a drain electrode 22 which are arranged on the electron supplying layer 18; an insulating layer 34 which is arranged so as to cover the gate electrode 24, the electron supplying layer 18 between the gate electrode 24 and the source electrode 20, the electron supplying layer 18 between the gate electrode 24 and the drain electrode 22, at least a part of the source electrode 20, and at least a part of the drain electrode 22; a shield plate electrode 30 which is arranged over the electron supplying layer 18 between the gate electrode 24 and the drain electrode 22 via the insulating layer 34, is short-circuited to the source electrode 20, and shields electrically the gate electrode 24 and the drain electrode 22 from each other. A two-dimensional electron gas (2DEG) layer 16 is formed in an interface of the epitaxial layer 12 and the electron supplying layer 18. A high-electron mobility transistor (HEMT) is shown in Fig. 4.

As a specific material, in the case of a GaAs system HEMT, the substrate 10 is formed by a GaAs substrate, the epitaxial layer 12 is formed by a GaAs layer, and the electron supplying layer 18 is formed by an aluminum gallium arsenide layer (Al_{y}Ga_{1-y}As) (0.1≤y≤1), for example. In the case of a GaN system HEMT, the substrate 10 is formed by a GaN substrate or a SiC substrate, the epitaxial layer 12 is formed by a GaN layer, and the electron supplying layer 18 is formed by an aluminum gallium nitride layer (AlₓGa₁₋ₓN) (0.1≤x≤1), for example. In the constructional example 1 shown in Fig. 4, the substrate 10, the epitaxial layer 12 and the electron supplying layer 18 correspond to the substrate 10 in Fig. 3 as a whole.

### (Constructional example 2)

Fig. 5 shows a constructional example 2 of an FET cell 40 by a schematic cross section taken along the I-I line of Fig. 1. The FET cell 40 includes: a substrate 10; an epitaxial layer 12 which is arranged on the substrate 10; a source region 26 and a drain region 28 which are arranged in the epitaxial layer 12; a source electrode 20 which is arranged on the source region 26; a gate electrode 24 which is arranged on the epitaxial layer 12; a drain electrode 22 which is arranged on the drain region 28; an insulating layer 34 which is arranged so as to cover the gate electrode 24, the epitaxial layer 12 between the gate electrode 24 and the source electrode 20, the epitaxial layer 12 between the gate electrode 24 and the drain electrode 22, at least a part of the source electrode 20, and at least a part of the drain electrode 22; a shield plate electrode 30 which is arranged over the epitaxial layer 12 between the gate electrode 24 and the drain electrode 22, and the drain electrode 22 via the insulating layer 34, is short-circuited to the source electrode 20, and shields electrically the gate electrode 24 and the drain electrode 22 from each other. A schottky contact is formed in an interface of the epitaxial layer 12 and the gate electrode 24. A metal semiconductor field effect transistor (MESFET) is shown in Fig. 5. For example, in the case of the GaAs MESFET, the substrate 10 is formed by a GaAs substrate, and the epitaxial layer 12 is formed by an epitaxially grown GaAs layer. The source region 26 and the drain region 28 can be formed by ion implantation, such as Si ion etc. In the constructional example 2 shown in Fig. 5, the substrate 10 and the epitaxial layer 12 correspond to the substrate 10 in Fig. 3 as a whole.

### (Constructional example 3)

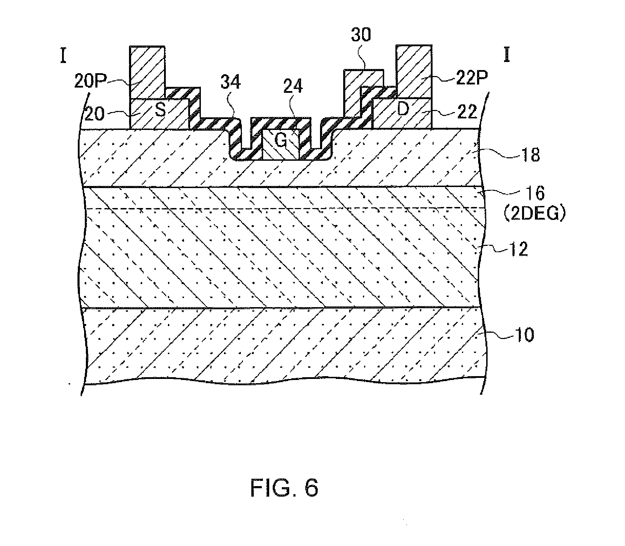

Fig. 6 shows a constructional example 3 of an FET cell 40 by a schematic cross section taken along the I-I line of Fig. 1. The FET cell 40 includes: a substrate 10; an epitaxial layer 12 which is arranged on the substrate 10; an electron supplying layer 18 which is arranged on the epitaxial layer 12; a source electrode 20 and a drain electrode 22 which are arranged on the electron supplying layer 18; a gate electrode 24 which is arranged on a recess part of the electron supplying layer 18; an insulating layer 34 which is arranged so as to cover the gate electrode 24, the electron supplying layer 18 between the gate electrode 24 and the source electrode 20, the electron supplying layer 18 between the gate electrode 24 and the drain electrode 22, at least a part of the source electrode 20, and at least a part of the drain electrode 22; and a shield plate electrode 30 which is arranged over the electron supplying layer 18 between the gate electrode 24 and the drain electrode 22, and the drain electrode 22 via the insulating layer 34, is short-circuited to the source electrode 20, and shields electrically the gate electrode 24 and the drain electrode 22 from each other. A 2DEG layer 16 is formed in an interface of the epitaxial layer 12 and the electron supplying layer 18. An HEMT is shown in Fig. 6.

As a specific material, in the case of a GaAs system HEMT, the substrate 10 is formed by a GaAs substrate, the epitaxial layer 12 is formed by a GaAs layer, and the electron supplying layer 18 is formed by an aluminum gallium arsenide layer (Al_{y}Ga_{1-y}As) (0.1≤y≤1), for example. In addition, in the case of the GaAs system HEMT, an activity layer may be formed by ion implantation of Si ion etc. in the electron supplying layer 18 directly under the gate electrode 24.

In the case of a GaN system HEMT, the substrate 10 is formed by a GaN substrate or an SiC substrate, the epitaxial layer 12 is formed by a GaN layer, and the electron supplying layer 18 is formed by an aluminum gallium nitride layer (AlₓGa₁₋ₓN) (0.1≤x≤1), for example. In the construtional example 3 shown in Fig. 6, the substrate 10, the epitaxial layer 12 and the electron supplying layer 18 correspond to the substrate 10 in Fig. 3 as a whole.

### (Constructional example 4)

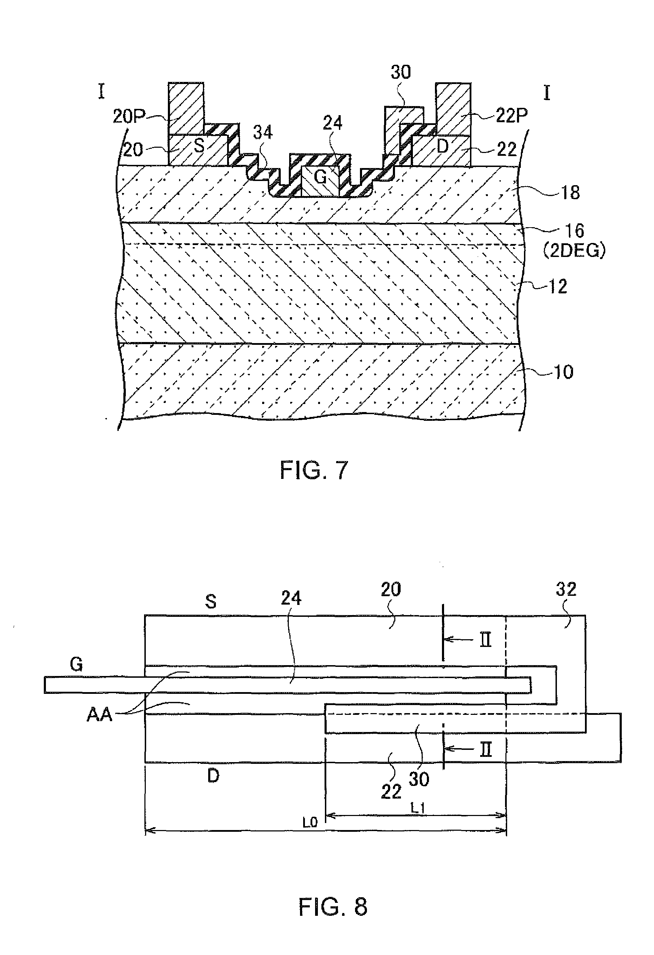

Fig. 7 shows a constructional example 4 of an FET cell 40 by a schematic cross section taken along the I-I line of Fig. 1. The FET cell 40 includes: a substrate 10; an epitaxial layer 12 which is arranged on the substrate 10; an electron supplying layer 18 which is arranged on the epitaxial layer 12; a source electrode 20 and a drain electrode 22 which are arranged on the electron supplying layer 18; a gate electrode 24 which is arranged on a two-step recess part of the electron supplying layer 18; an insulating layer 34 which is arranged so as to cover the gate electrode 24, the electron supplying layer 18 between the gate electrode 24 and the source electrode 20, the electron supplying layer 18 between the gate electrode 24 and the drain electrode 22, at least a part of the source electrode 20, and at least a part of the drain electrode 22; and a shield plate electrode 30 which is arranged over the electron supplying layer 18 between the gate electrode 24 and the drain electrode 22, and the drain electrode 22 via the insulating layer 34, is short-circuited to the source electrode 20, and shields electrically the gate electrode 24 and the drain electrode 22 from each other. A 2DEG layer 16 is formed in an interface of the epitaxial layer 12 and the electron supplying layer 18. An HEMT is shown in Fig. 7.

As a specific material, in the case of a GaAs system HEMT, the substrate 10 is formed by a GaAs substrate, the epitaxial layer 12 is formed by a GaAs layer, and the electron supplying layer 18 is formed by an aluminum gallium arsenide layer (Al_{y}Ga_{1-y}As) (0.1≤y≤1), for example. In addition, in the case of a GaAs system HEMT, an activity layer may be formed by ion implantation of Si ion etc. in the electron supplying layer 18 directly under the gate electrode 24.

In the case of a GaN system HEMT, the substrate 10 is formed by a GaN substrate or an SiC substrate, the epitaxial layer 12 is formed by a GaN layer, and the electron supplying layer 18 is formed by an aluminum gallium nitride layer (AlₓGa₁₋ₓN) (0.1≤x≤1), for example. In the constructional example 4 shown in Fig. 7, the substrate 10, the epitaxial layer 12 and the electron supplying layer 18 correspond to the substrate 10 in Fig. 3 as a whole.

In addition, in the semiconductor device 25 concerning the first embodiment, as for the gate electrode 24, a cross-section shape of the gate electrode 24 in a cross-section in a direction of a channel between the source and the drain may be formed in T type so that the electric field in the circumference of the gate electrode 24 may be relaxed.

### (Modification 1)

Fig. 8 shows a schematic plane pattern structure of a semiconductor device concerning a modification 1 of the first embodiment. In the semiconductor device concerning the modification 1, a shield plate electrode 30 is arranged overlapping with a part of the drain electrode 22. That is, a length L0 of the drain electrode 22 which is in contact with an active region AA, and a length L1 of the shield plate electrode 30 which is arranged on the active region AA, are in a relation of L1<L0. Here, the active region AA corresponds to an active current conduction region of a substrate 10 between a source electrode 20 and a drain electrode 22. The active region AA also includes each region of the substrate 10 under the gate electrode 24, the source electrode 20, and the drain electrode. In addition, the active region AA also includes a region of the substrate 10 between the gate electrode 24 and the source electrode 20 and a region of the substrate between the gate electrode 24 and the drain electrode 22.

In Fig. 8, a schematic cross section taken along a II-II line is the same as that of Fig. 3.

In the semiconductor device concerning the modification 1, since the shield plate electrode 30 is arranged so as to overlap with a part of the drain electrode 22, the gate and the drain can be shielded electrically from each other and a capacitance Cgd between the gate and the drain can be reduced, and ane increase in a capacitance Cgs between the gate and the source can be suppressed. As a result, according to the modification 1, a semiconductor device of high gain can be obtained. Other composition is the same as that of the first embodiment.

### (Modification 2)

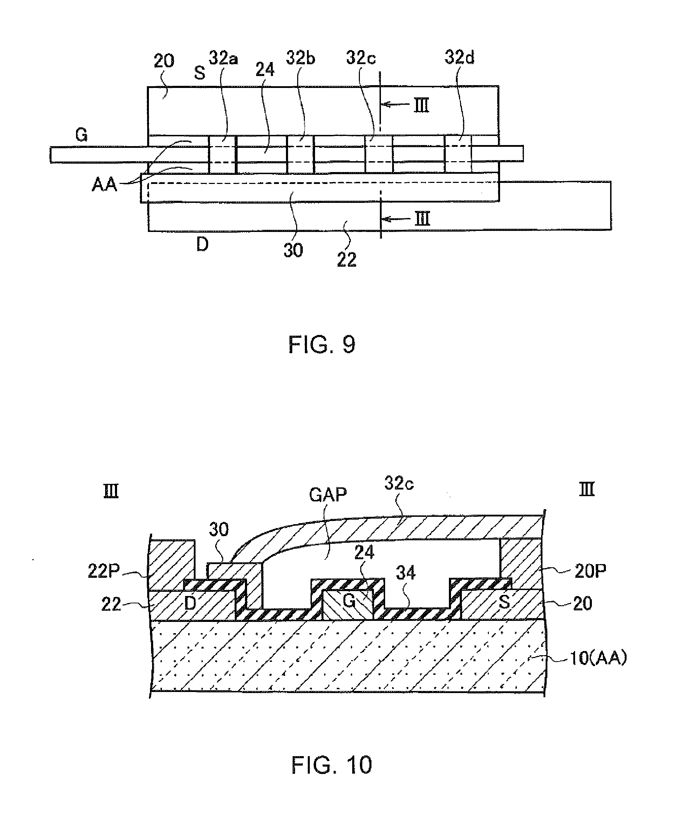

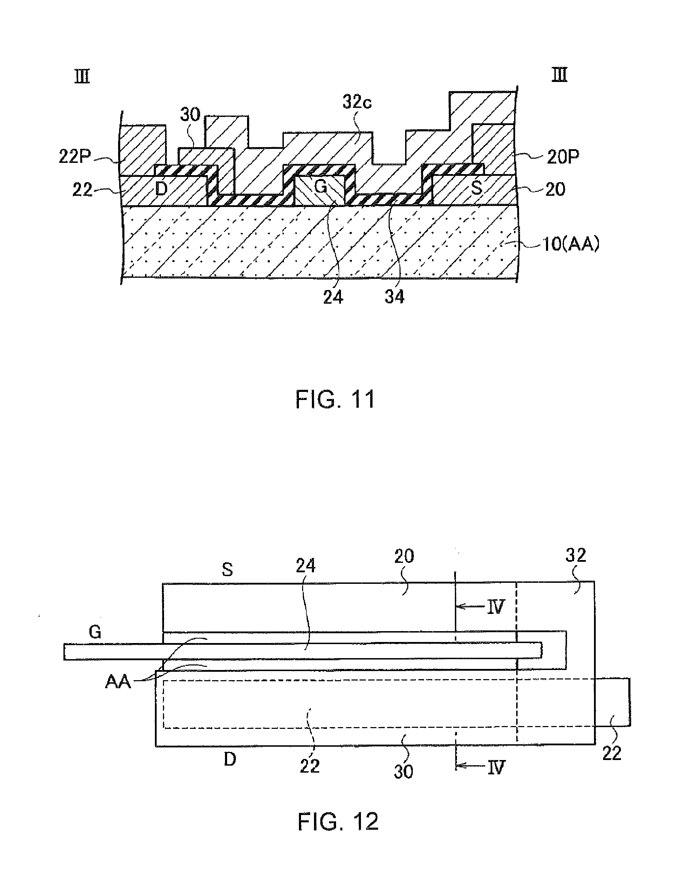

Fig. 9 shows a schematic plane pattern configuration of a high-frequency semiconductor device concerning a modification 2 of the first embodiment. Fig. 10 shows a schematic cross section taken along a III-III line in Fig. 9, and Fig. 11 shows another schematic cross section taken along a III-III line in Fig. 9.

In the semiconductor device concerning the modification 2, shield plate short circuit lines 32a, 32b, 32c and 32d are arranged overlapping with gate electrode 24.

In Fig. 10, the shield plate short circuit line 32c is arranged via air gap GAP over the gate electrode 24. And in Fig. 11, the shield plate short circuit line 32c is arranged via an insulating layer 34 over the gate electrode 24. Other composition is the same as that of the first embodiment.

In the first embodiment shown in Fig. 2 and the modification 1 shown in Fig. 8, if a stripe of the gate electrode 24 becomes long, the length of the source electrode 20 and the shield plate short circuit line 32 in the extension direction will become long. For this reason, the line which short-circuits the source electrode 20 and the shield plate electrode 30 becomes long, and thereby inductance of a parasitic inductor connected to the source of the FET cell increases.

On the other hand, in the semiconductor device concerning the modification 2, since the shield plate short circuit lines 32a, 32b, 32c and 32d are arranged so as to overlap with the gate electrode 24 via air gap GAP or the insulating layer 34, a line which short circuits the source electrode 20 and the shield plate electrode 30 can be shortened. For this reason, inductance of the parasitic inductor connected to the sauce of the FET cell can be reduced and feedback impedance of each FET cell can be reduced.

In the semiconductor device concerning the modification 2, the drain and the gate are shielded electrically from each other, the capacitance Cgd between the gate and the drain can be reduced, and the increase in the capacitance Cgs between the gate and the source can be controlled. Accordingly, the concentration of electric field between the gate and the drain can be relaxed without degrading a high-frequency characteristic.

In the semiconductor device 25 concerning the modification 2, since the capacitance Cgd between the gate and the drain can be reduced, S parameter S12 can be reduced. According to the modification 2, a semiconductor device of high gain can be obtained.

### [Second embodiment]

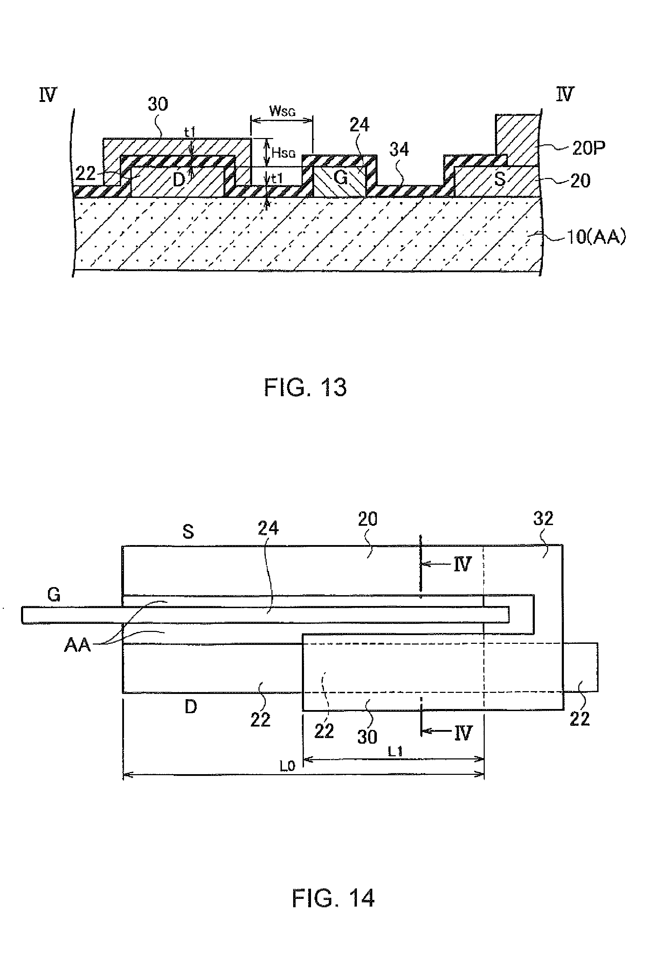

A schematic plane pattern structure of a semiconductor device 25 concerning a second embodiment is similarly expressed as Fig. 1. Fig. 12 shows a schematic plane pattern composition of a unit transistor portion of the semiconductor device concerning the second embodiment, and Fig. 13 shows a schematic cross section taken along a IV-IV line in Fig. 12.

Also in the semiconductor device 25 concerning the second embodiment, the same FET cell structure as the FET cell structure of Fig. 4 to Fig. 7 can be constituted. In this case, a shield plate electrode 30 is constituted as shown in Fig. 12 and Fig. 13.

The semiconductor device 25 concerning the second embodiment is provided with a substrate 10, a gate electrode 24, a source electrode 20, a drain electrode 22, an insulating layer 34, and a shield plate electrode 30 as shown in Fig. 12 - Fig. 13.

The gate electrode G is arranged on a first surface of the substrate 10, and has a plurality of gate finger electrodes 24. The source electrode S is arranged on the first surface of the substrate 10, and has a plurality of source finger electrodes 20. The source finger electrode 20 is arranged close to the gate finger electrode 24. The drain electrode D is arranged on the first surface of the substrate 10, and has a plurality of drain finger electrodes 22. The drain finger electrode 22 is arranged facing the source finger electrode 20 via the gate finger electrode 24.

As shown in Fig. 13, the insulating layer 34 is arranged so as to cover the gate electrode 24, the drain electrode 22, the substrate 10 between the gate electrode 24 and the drain electrode 22, the substrate 10 between the gate electrode 24 and the drain electrode 22, and at least a part of the source electrode 20.

As shown in Fig. 13, the shield plate electrode 30 is arranged over the gate electrode 22 and a first surface of the substrate 10 between the gate electrode 24 and the drain electrode 22 via an insulating layer 34, is short-circuited to the source electrode 20, and shields electrically the gate electrode 24 and the drain electrode 22 from each other.
In the semiconductor device 25 concerning the second embodiment, since the shield plate electrode 30 is arranged over the drain electrode 22 via the insulating layer 34, as shown in Fig. 13, the effect of electric shield between the gate electrode 24 and the drain electrode 22 is increased compared with first embodiment.

As shown in Fig. 13, the shield plate electrode 30 is arranged so as to be separated from the gate electrode 24 by at least only a distance WSG longer than a thickness t1 of the insulating layer. By constituting thus, an effect of electric shield between the drain and the gate is increased, a capacitance Cgd between the gate and the drain is reduced, and an increase in a capacitance Cgs between the gate and the source can be suppressed. Here, the shield plate electrode 30 should just be arranged so as to be separated from the gate electrode 24 by at least only the distance WSG longer than the thickness t1 of the insulating layer. Here, what is necessary is just WSG>0.

In addition, the shield plate electrode 30 covers an upper part of the drain electrode 22 via the insulating layer 34, as shown in Fig. 12 and Fig. 13. As for the effect of electric shield between the gate and the drain by the shield plate electrode 30, the thinner thickness t1 of the insulating layer 34 is, the higher the effect is. In the case where the thickness t1 of the insulating layer 34 is relatively thick, the number of the lines of electric force which run the inside of the insulating layer 34 between the gate electrode 24 and the drain electrode 22 increases, and the effect of the electric shield between the gate electrode 24 and the drain electrode 22 is reduced. On the other hand, in the case where the thickness t1 of the insulating layer 34 is relatively thin, the number of the lines of electric force which run the inside of the insulating layer 34 between the gate electrode 24 and the drain electrode 22 decreases, and the effect of the electric shield between the gate electrode 24 and the drain electrode 22 increases.

As shown in Fig. 13, a source pad electrode 20P may be arranged on the source electrode 20. With the source pad electrode 20P, a resistance ingredient of the source electrode S which has a finger structure can be reduced.

The semiconductor device 25 concerning the second embodiment is provided with a shield plate short circuit line 32 of line structure which is arranged on the substrate 10 and which short-circuits the shield plate electrode 30 and the source electrode 20 as shown in Fig. 12.

In the semiconductor device 25 concerning the second embodiment, by arranging the shield plate electrode 30 which is short-circuited to the source electrode near the drain electrode 22, the drain and the gate are electrically shielded from each other, a capacitance Cgd between the gate and the drain is reduced, and an increase in a capacitance Cgs between the gate and the source can be suppressed. Accordingly, the concentration of electric field between the gate and the drain can be relaxed without degrading a high-frequency characteristic.

The capacitance Cgd between the gate and the drain can be reduced in the semiconductor device 25 concerning the second embodiment. As a result, S parameter S12 can be reduced and a semiconductor device of high gain can be obtained.

Since other composition is the same as that of the first embodiment, overlapping explanation is omitted.

### (Modification 1)

Fig. 14 shows a schematic plane pattern composition of a semiconductor device concerning a modification 1 of the second embodiment. In the semiconductor device concerning the modification 1 of the second embodiment, the shield plate electrode 30 is arranged overlapping with a part of drain electrode 22. That is, a length L0 of the drain electrode 22 which is in contact with an active region AA, and a length L1 of the shield plate electrode 30 which is arranged on the active region AA, are in a relation of L1<L0.

In Fig. 14, a schematic cross section taken along an IV-IV line is the same as that of Fig. 13.

In the semiconductor device concerning the modification 1 of the second embodiment, the shield plate electrode 30 is arranged so as to overlap with a part of the drain electrode 22. Accordingly, a drain and a gate are shielded electrically from each other, a capacitance Cgd between the gate and the drain is reduced, and furthermore an increase in a capacitance Cgs between the gate and the source can be suppressed. As a result, according to the modification 1 of the second embodiment, the semiconductor device of high gain can be obtained. Other composition is the same as that of the second embodiment.

### (Modification 2)

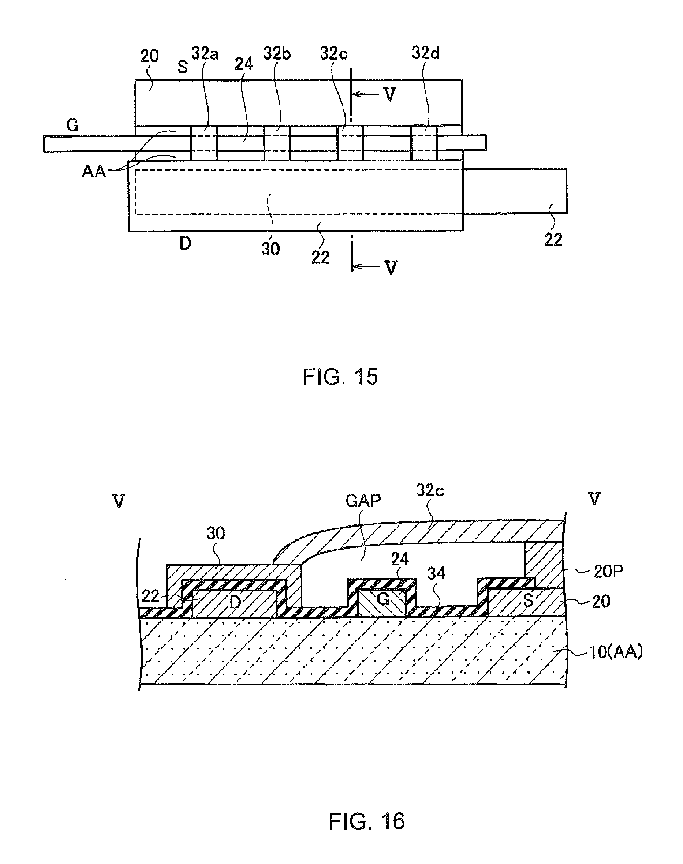

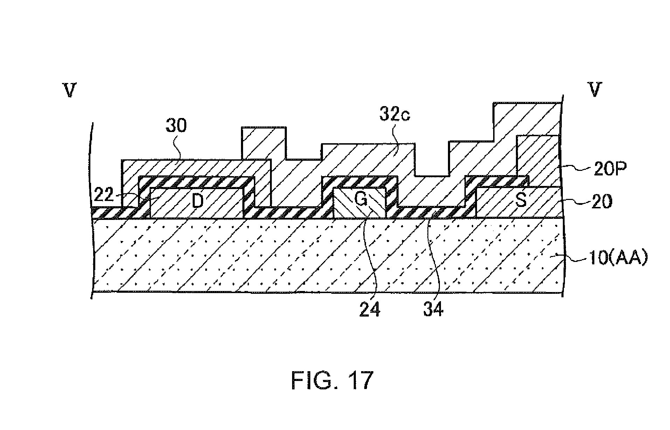

Fig. 15 shows a schematic plane pattern structure of a high-frequency semiconductor device concerning a modification 2 of he second embodiment. In addition, Fig. 16 shows a schematic cross section taken along a V-V line in Fig. 15, and Fig. 17 shows another schematic cross section taken along the V-V line in Fig. 15.

In the semiconductor device concerning the modification 2 of the second embodiment, shield plate short circuit lines 32a, 32b, 32c and 32d are arranged so as to overlap with the gate electrode 24.

In Fig. 16, the shield plate short circuit line 32c is arranged via air gap GAP over the gate electrode 24. And in Fig. 17, the shield plate short circuit line 32c is arranged via the insulating layer 34 over the gate electrode 24. Other composition is the same as that of second embodiment.

In the second embodiment shown in Fig. 12 and its modification 1 in Fig. 14, if the stripe of the gate electrode 24 becomes long, a length of the extension direction of the source electrode 20 and the shield plate short circuit line 32 will become long. For this reason, a line to short-circuit the source electrode 20 and the shield plate electrode 30 becomes long, and thereby a value of an inductance of a parasitic inductance connected to the source of the FET cell increases.

On the other hand, in the semiconductor device concerning the modification 2 of the second embodiment, since the shield plate short circuit lines 32a, 32b, 32c and 32d are arranged so as to overlap with the gate electrode 24 via air gap GAP or the insulating layer 34, a length of a line which short-circuits the source electrode 20 and the shield plate electrode 30 can be shortened. For this reason, an inductance of a parasitic inductor connected to the source of the FET cell can be reduced, and the feedback impedance of each FET cell can be reduced.

In the semiconductor device concerning the modification 2 of the second embodiment, the drain and the gate are shielded electrically from each other, a capacitance Cgd between the gate and the drain is reduced, and an increase in a capacitance Cgs between the gate and the source can be suppressed. Accordingly, the concentration of electric field between the gate and the drain can be relaxed without degrading a high-frequency characteristic.

According to the modification 2 of the second embodiment, since the capacitance Cgd between the gate and the drain can be reduced, S parameter S12 can be reduced and a semiconductor device of high gain can be obtained.

As explained above, according to this embodiment, a semiconductor device of high gain can be provided.

### [Other embodiments]

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

As for a semiconductor chip carried in the semiconductor device concerning the embodiments, not only FET and HEMT but an amplification element, such as a LDMOS (Laterally Diffused Metal-Oxide-Semiconductor Field Effect Transistor), an HBT (Hetero-junction Bipolar Transistor), etc. can be used.

## Claims

1. A semiconductor device, comprising:
a substrate;
a gate electrode which is arranged on a first surface of the substrate and has a plurality of gate finger electrodes,
a source electrode which is arranged on the first surface of the substrate and has a plurality of source finger electrodes, the source finger electrode is close to the gate finger electrode;
a drain electrode which is arranged on the first surface of the substrate and has a plurality of drain finger electrodes, the drain finger electrode faces the source finger electrode via the gate finger electrode;
an insulating layer which covers the gate finger electrode, the substrate between the gate finger electrode and the source finger electrode, the substrate between the gate finger electrode and the drain finger electrode, at least a part of the source finger electrode, and at least a part of the drain finger electrode; and
a shield plate electrode which is arranged over the drain finger electrode and the first surface of the substrate between the gate finger electrode and the drain finger electrode via the insulating layer, is short-circuited to the source finger electrode, and shields electrically the gate finger electrode and the drain finger electrode from each other.

2. The semiconductor device according to the claim 1, wherein the shield plate electrode is separated from the gate finger electrode by at least a distance longer than a thickness of the insulating layer.

3. The semiconductor device according to the claim 1, wherein the shield plate electrode covers at least a part of upper part of the drain finger electrode via the insulating layer.

4. The semiconductor device according to the claim 1, further comprising a shield plate short circuit line which short-circuits the shield plate electrode and the source finger electrode.

5. The semiconductor device according to the claim 4, wherein the shield plate short circuit line overlaps with the gate finger electrode.

6. The semiconductor device according to the claim 4, wherein the shield plate short circuit line is arranged over the gate finger electrode via the insulating layer.

7. The semiconductor device according to the claim 4, wherein the shield plate short circuit line is arranged over the gate finger electrode via an air gap.

8. The semiconductor device according to the claim 1, wherein an upper end of the shield plate electrode measured from the first surface of the substrate is higher than an upper end of the gate finger electrode measured from the first surface of the substrate.

9. The semiconductor device according to the claim 1, further comprising:
a gate terminal electrode which is arranged on the first surface of the substrate and is connected to a plurality of the gate finger electrodes;
a source terminal electrode which is arranged on the first surface of the substrate and is connected to a plurality of the source finger electrodes;
a drain terminal electrode which is arranged on the first surface of the substrate and is connected to a plurality of the drain finger electrodes;
a VIA hole which is formed in the substrate under the source terminal electrode;
a ground electrode which is arranged on a second surface of the substrate opposite to the first surface of the substrate, and which is connected to the source terminal electrode via the VIA hole.

10. The semiconductor device according to the claim 1, wherein the substrate is any one of a GaAs substrate, an SiC substrate, a GaN substrate, a substrate in which a GaN epitaxial layer is formed on the SiC substrate, a substrate in which a hetero-junction epitaxial layer which consists of GaN/AlGaN is formed on the SiC substrate, a sapphire substrate and a diamond substrate.

11. The semiconductor device according to the claim 1, wherein the semiconductor device is provided wit any one of a GaAs system HEMT, a GaAs MESFET and a GaN system HEMT.
